# EUROPEAN PATENT APPLICATION

(11) **EP 4 053 912 A1**
(43) Date of publication of application: **07.09.2022**
(21) Application number: 22159969.9
(22) Date of filing: 03.03.2022
(51) Int. Cl.: H01L 29/417, H01L 29/423

(54) **SEMICONDUCTOR DEVICE AND METHOD FOR MANUFACTURING THE SAME**

(30) Priority: 05.03.2021 JP 2021034898; 21.10.2021 JP 2021172417
(71) Applicant: Sumitomo Electric Device Innovations, Inc., Yokohama-shi, Kanagawa, 224-0845 (JP)
(72) Inventor: Matsumoto, Takuya, Yokohama-shi, 244-0845 (JP)
(74) Representative: Grünecker Patent- und Rechtsanwälte PartG mbB

(57) **Abstract**

A semiconductor device includes a substrate, a first source finger provided on the substrate, a first gate finger provided adjacent to the first source finger in a width direction of the first source finger, a second source finger having a width smaller than a width of the first source finger, a second gate finger provided adjacent to the second source finger in the width direction of the second source finger, a first source wiring connecting the first source finger to the second source finger, a first gate wiring sandwiching the second source finger between the first gate wiring and the second gate finger, a second gate wiring intersecting the first source wiring in a non-contact manner, and connecting the first gate wiring to the first gate finger, and a first drain finger sandwiching the first gate finger and the second gate finger between the first drain finger.

## Description

### FIELD

The present disclosure relates to a semiconductor device and a method for manufacturing the same, for example, a semiconductor device having a field effect transistor and a method for manufacturing the same.

### BACKGROUND

In the field effect transistor (FET) having a source, a gate and a drain, it is known to arrange a plurality of unit FETs having a source finger, a gate finger and a drain finger in an extension direction of the fingers (e.g., Patent Document 1: Japanese Laidopen Patent Publication No. 2002-299351).

### SUMMARY

A semiconductor device according to the present disclosure includes a substrate; a first source finger provided on the substrate; a first gate finger provided on the substrate, along the first source finger, and adjacent to the first source finger in a width direction of the first source finger; a second source finger provided on the substrate, having a width smaller than a width of the first source finger, and extending in an extension direction of the first source finger, the width of the second source finger in the width direction being within the width of the first source finger; a second gate finger provided on the substrate and adjacent to the second source finger in the width direction of the second source finger, the second gate finger extending in an extension direction of the first gate finger; a first source wiring provided on the substrate and connecting the first source finger to the second source finger; a first gate wiring provided on the substrate and sandwiching the second source finger between the first gate wiring and the second gate finger, the width of the first gate wiring in the width direction being within the width of the first source finger; a second gate wiring provided on the substrate, intersecting the first source wiring in a non-contact manner, and connecting the first gate wiring to the first gate finger; and a first drain finger provided on the substrate and sandwiching the first gate finger and the second gate finger between the first drain finger, and the first source finger and the second source finger.

A method for manufacturing a semiconductor device according to the present disclosure includes forming, in a substrate, a first active region and a second active region separated from each other and in which a semiconductor layer is activated, and an inactive region provided between the first active region and the second active region and in which the semiconductor layer is deactivated; forming, on the first active region, a first source ohmic layer and a first drain ohmic layer provided adjacent to the first source ohmic layer in a width direction of the first source ohmic layer and along the first source ohmic layer; forming, on the second active region, a second source ohmic layer having a width smaller than the width of the first source ohmic layer and extending in an extension direction of the first source ohmic layer, the width of the second source ohmic layer in a width direction being within the width of the first source ohmic layer, and a second drain ohmic layer provided adjacent to the second source ohmic layer in a width direction of the second source ohmic layer and along the second source ohmic layer; forming, on the first active region, a first gate finger sandwiched between the first source ohmic layer and the first drain ohmic layer and provided adjacent to the first source ohmic layer in the width direction of the first source ohmic layer and along the first source ohmic layer; forming, on the second active region, a second gate finger sandwiched between the second source ohmic layer and the second drain ohmic layer and extending in an extension direction of the first gate finger; forming, on the substrate, a first gate wiring sandwiching the second source ohmic layer between the second gate finger and the first gate wiring, the width of the first gate wiring in the width direction being within the width of the first source ohmic layer; and forming, on the inactive region, a second gate wiring connecting the first gate finger to the first gate wiring.

### BRIEF DESCRIPTION OF DRAWINGS

FIG. 1 is a plan view illustrating a semiconductor device according to a first embodiment.
FIG. 2 is a cross-sectional view taken along line A-A of FIG. 1.
FIG. 3 is a cross-sectional view taken along line B-B of FIG. 1.
FIG. 4 is a cross-sectional view taken along line C-C of FIG. 1.
FIG. 5 is a cross-sectional view taken along line D-D of FIG. 1.
FIG. 6 is a plan view illustrating a semiconductor device according to a first variation of the first embodiment.
FIG. 7 is a plan view illustrating a semiconductor device according to a second variation of the first embodiment.
FIG. 8 is a plan view illustrating a semiconductor device according to a third variation of the first embodiment.
FIG. 9 is a plan view illustrating a semiconductor device according to a second embodiment.
FIG. 10 is a plan view illustrating a semiconductor device according to a first variation of the second embodiment.
FIG. 11 is a plan view illustrating a semiconductor device according to a second variation of the second embodiment.
FIG. 12 is a plan view illustrating a semiconductor device according to a third variation of the second embodiment.
FIG. 13 is a plan view illustrating a semiconductor device according to a fourth variation of the second embodiment.
FIGs. 14A to 14C are cross-sectional views illustrating a method for manufacturing a semiconductor device according to a third embodiment.
FIGs. 15A to 15C are cross-sectional views illustrating a method for manufacturing the semiconductor device according to the third embodiment.
FIG. 16 is a plan view illustrating a method for manufacturing the semiconductor device according to the third embodiment.
FIG. 17 is a plan view illustrating a method for manufacturing the semiconductor device according to the third embodiment.
FIG. 18 is a plan view illustrating a method for manufacturing the semiconductor device according to the third embodiment.
FIG. 19 is a plan view illustrating a semiconductor device according to a first variation of the third embodiment.
FIG. 20 is a plan view illustrating a semiconductor device according to a first variation of the third embodiment.
FIG. 21 is a plan view illustrating a semiconductor device according to a second variation of the third embodiment.
FIG. 22 is a plan view illustrating a semiconductor device according to the second variation of the third embodiment.
FIG. 23 is a plan view illustrating a semiconductor device according to a third variation of the third embodiment.

### DETAILED DESCRIPTION OF EMBODIMENTS

In Patent Document 1, the plurality of unit FETs are arranged in the extension direction of the fingers, so that the gate finger in the unit FET can be shortened. Therefore, a gate resistance can be suppressed. However, a gate wiring for supplying a gate potential (gate signal) to the gate fingers of the unit FETs arranged in the extension direction of the fingers extends in the extension direction of the fingers. Thereby, the gate wiring overlaps with the source finger, resulting in increasing a gate-source capacitance. When the gate wiring and the source finger are arranged so that they do not overlap, the semiconductor device will become larger because a region for the gate wiring and a region for the source finger are separate.

It is an object of the present disclosure to provide a semiconductor device and a method for manufacturing a semiconductor device that can be reduced in size.

### [Description of Embodiments of the Present Disclosure]

First, the contents of the embodiments of this disclosure are listed and explained.

### [Details of Embodiments of the Present Disclosure]

(1) A semiconductor device according to the present disclosure includes a substrate; a first source finger provided on the substrate; a first gate finger provided on the substrate, along the first source finger, and adjacent to the first source finger in a width direction of the first source finger; a second source finger provided on the substrate, having a width smaller than a width of the first source finger, and extending in an extension direction of the first source finger, the width of the second source finger in the width direction being within the width of the first source finger; a second gate finger provided on the substrate and adjacent to the second source finger in the width direction of the second source finger, the second gate finger extending in an extension direction of the first gate finger; a first source wiring provided on the substrate and connecting the first source finger to the second source finger; a first gate wiring provided on the substrate and sandwiching the second source finger between the first gate wiring and the second gate finger, the width of the first gate wiring in the width direction being within the width of the first source finger; a second gate wiring provided on the substrate, intersecting the first source wiring in a non-contact manner, and connecting the first gate wiring to the first gate finger; and a first drain finger provided on the substrate and sandwiching the first gate finger and the second gate finger between the first drain finger, and the first source finger and the second source finger. This makes it possible to provide the semiconductor device that can be reduced in size.
(2) The semiconductor device may include a via penetrating the substrate and connecting the first source finger to a metal layer provided under the substrate.
(3) The semiconductor device may further include a third gate finger provided on the substrate and sandwiching the first source finger between the first gate finger and the third gate finger; a third source finger provided on the substrate, having a width smaller than the width of the first source finger, extending in the stretching direction, being adjacent to the first gate wiring in the width direction, and sandwiching the first gate wiring between the second source finger and the third source finger, the width of the third source finger in the width direction being within the width of the first source finger; a fourth gate finger provided on the substrate, sandwiching the third source finger between the first gate wiring and the fourth gate finger, and extending in an extension direction of the third gate finger; a second drain finger provided on the substrate and sandwiching the third gate finger and the fourth gate finger between the second drain finger, and the first source finger and the third source finger; and a second source wiring provided on the substrate and connecting the first source finger to the third source finger; wherein the second gate wiring intersects the second source wiring in a non-contact manner and connects the first gate wiring to the third gate finger.
(4) The semiconductor device preferably includes a gate bus bar provided on a region of the substrate opposite to the first source finger with respect to the second source finger and connected to the first gate wiring.
(5) The second gate finger may have a first end connected to the gate bus bar, and a second end separated from the second gate wiring.
(6) The second gate finger may have a first end separated from the gate bus bar, and a second end connected to the second gate wiring.
(7) The second gate finger may have a first end connected to the gate bus bar, and a second end connected to the second gate wiring.
(8) The semiconductor device may further include: a third gate finger provided on the substrate and sandwiching the first source finger between the first gate finger and the third gate finger; a third source finger provided on the substrate, having a width smaller than the width of the first source finger, extending in the stretching direction, being adjacent to the first gate wiring in the width direction, and sandwiching the first gate wiring between the second source finger and the third source finger, the width of the third source finger in the width direction being within the width of the first source finger, a fourth gate finger provided on the substrate, sandwiching the third source finger between the first gate wiring and the fourth gate finger, and extending in an extension direction of the third gate finger; a second drain finger provided on the substrate and sandwiching the third gate finger and the fourth gate finger between the second drain finger, and the first source finger and the third source finger; and a second source wiring provided on the substrate and connecting the first source finger to the third source finger; a third gate wiring provided on the substrate and between the third source finger and the first gate wiring, and separated from the first gate wiring on the substrate, the width of the third gate wiring in the width direction being within the width of the first source finger; and a fourth gate wiring provided on the substrate, intersecting the second source wiring in a non-contact manner, separated from the second gate wiring on the substrate, and connecting the third gate wiring to the third gate finger.
(9) The semiconductor device may further include: a first gate bus bar provided on a region of the substrate opposite to the first source finger with respect to the second source finger and connected to the first gate wiring; a second gate bus bar provided on a region of the substrate opposite to the first source finger with respect to the third source finger, connected to the first gate wiring, and separated from the first gate bus bar on the substrate; and a resistor electrically connecting the first gate wiring and the first gate bus bar to the third gate wiring and the second gate bus bar.
(10) The substrate may have a first active region and a second active region separated from each other and in which a semiconductor layer in the substrate is activated, and an inactive region provided between the first active region and the second active region and in which the semiconductor layer is deactivated. The first source finger may have a first source ohmic layer that makes ohmic contact with the first active region, and a first source low resistance layer provided in contact with the first source ohmic layer and having a sheet resistance lower than the first source ohmic layer. The second source finger may have a second source ohmic layer that makes ohmic contact with the second active region, and a second source low resistance layer provided in contact with the second source ohmic layer and having a sheet resistance lower than the second source ohmic layer. The second gate wiring may be provided on the inactive region. The first source wiring may be continuous with the first source low resistance layer and the second source low resistance layer and be formed of the same material as the first source low resistance layer and the second source low resistance layer.
(11) The first drain finger may have a first drain ohmic layer that makes ohmic contact with the first active region, a second drain ohmic layer that makes ohmic contact with the second active region, and a drain low resistance layer in contact with the first drain ohmic layer and the second drain ohmic layer and having a lower sheet resistance than the first drain ohmic layer and the second drain ohmic layer.
(12) A material of the second gate wiring may be the same as that of the first gate finger and the second gate finger.
(13) A sheet resistance of the second gate wiring may be lower than that of the first gate finger and the second gate finger.
(14) A method for manufacturing a semiconductor device according to the present disclosure includes: forming, in a substrate, a first active region and a second active region separated from each other and in which a semiconductor layer is activated, and an inactive region provided between the first active region and the second active region and in which the semiconductor layer is deactivated; forming, on the first active region, a first source ohmic layer and a first drain ohmic layer provided adjacent to the first source ohmic layer in a width direction of the first source ohmic layer and along the first source ohmic layer; forming, on the second active region, a second source ohmic layer having a width smaller than the width of the first source ohmic layer and extending in an extension direction of the first source ohmic layer, the width of the second source ohmic layer in a width direction being within the width of the first source ohmic layer, and a second drain ohmic layer provided adjacent to the second source ohmic layer in a width direction of the second source ohmic layer and along the second source ohmic layer; forming, on the first active region, a first gate finger sandwiched between the first source ohmic layer and the first drain ohmic layer and provided adjacent to the first source ohmic layer in the width direction of the first source ohmic layer and along the first source ohmic layer; forming, on the second active region, a second gate finger sandwiched between the second source ohmic layer and the second drain ohmic layer and extending in an extension direction of the first gate finger; forming, on the substrate, a first gate wiring sandwiching the second source ohmic layer between the second gate finger and the first gate wiring, the width of the first gate wiring in the width direction being within the width of the first source ohmic layer; and forming, on the inactive region, a second gate wiring connecting the first gate finger to the first gate wiring. This makes it possible to provide a method for manufacturing a semiconductor device that can be reduced in size.
(15) The method for manufacturing the semiconductor device may include forming a first source low resistance layer in contact with the first source ohmic layer and a second source low resistance layer in contact with the second source ohmic layer, wherein a source wiring connecting the first source low resistance layer to the second source low resistance layer and intersecting the second gate wiring in a non-contact manner is formed on the inactive region simultaneously with the first source low resistance layer and the second source low resistance layer.

### DETAILED DESCRIPTION OF EMBODIMENTS OF THE DISCLOSURE

Specific examples of a semiconductor device and a method for manufacturing the same in accordance with embodiments of the present disclosure are described below with reference to the drawings. The present disclosure is not limited to these examples, but is indicated by the claims, which are intended to include all modifications within the meaning and scope of the claims.

### FIRST EMBODIMENT

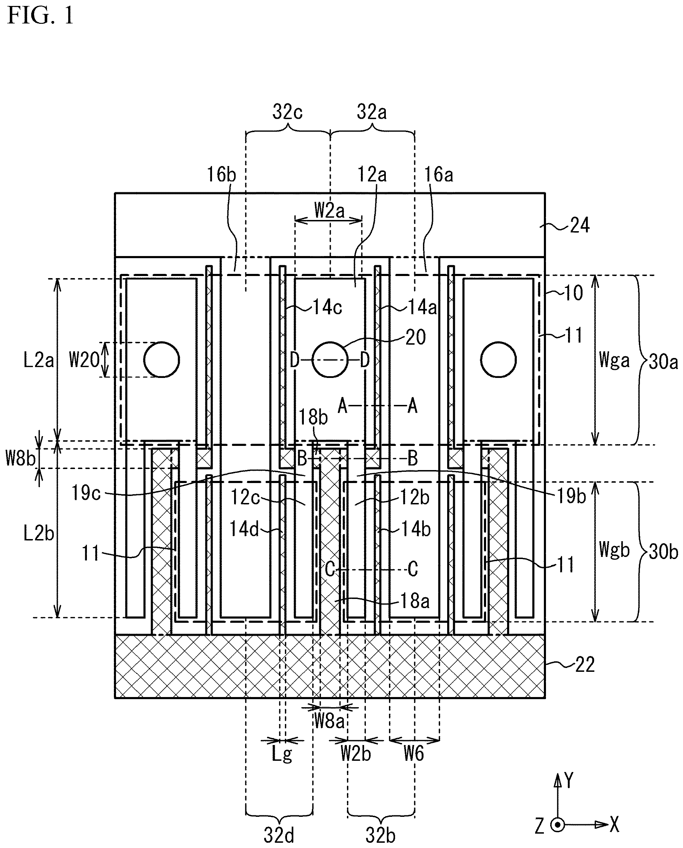

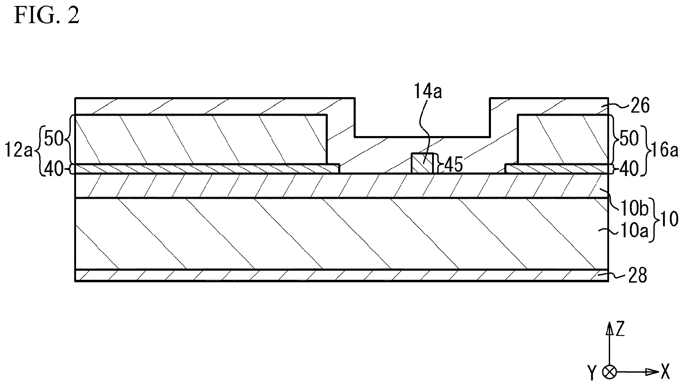

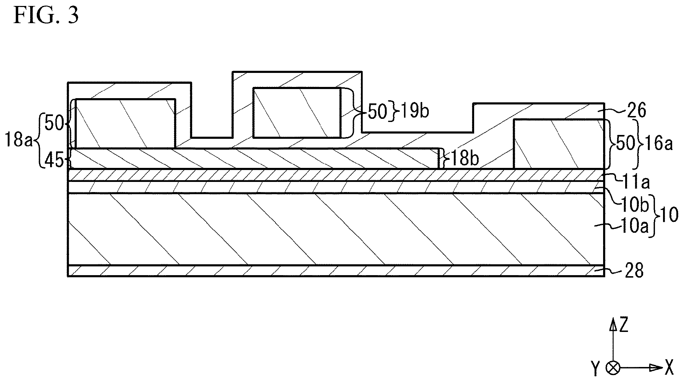

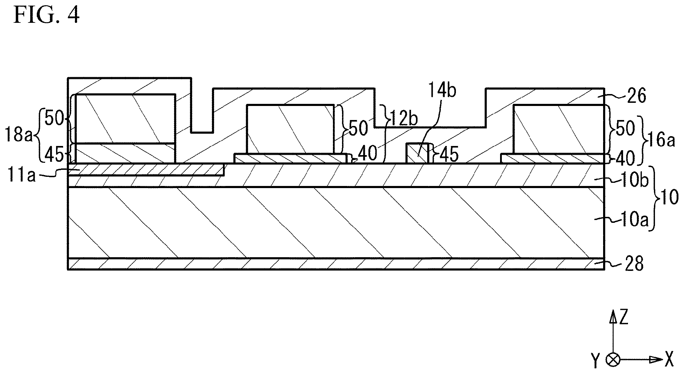

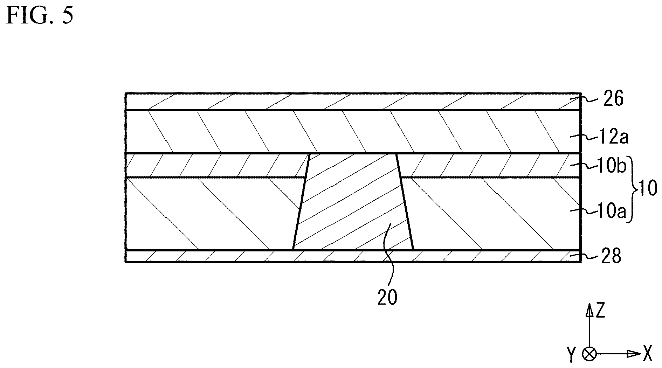

FIG. 1 is a plan view illustrating the semiconductor device according to a first embodiment. FIGs. 2 to 5 are cross-sectional views taken along lines A-A, B-B, C-C, D-D of FIG. 1, respectively. A normal direction of an upper surface of a substrate 10 is a Z direction, an extension direction of each finger is a Y direction, and a width direction of each finger is an X direction.

As illustrated in FIGs. 1 to 5, the substrate 10 includes a substrate 10a and a semiconductor layer 10b provided on the substrate 10a. A region where the semiconductor layer 10b is inactivated by ion implantation or the like is an inactive region 11a, and a region where it is not inactivated is an active region 11. Source fingers 12a to 12c, gate fingers 14a to 14d, drain fingers 16a and 16b, gate wirings 18a and 18b, a gate bus bar 22 and a drain bus bar 24 are provided on the substrate 10.

Each of the source fingers 12a to 12c and the drain fingers 16a and 16b has an ohmic metal layer 40 provided on the active region 11 and a low resistance layer 50 provided on the ohmic metal layer 40. The ohmic metal layer 40 makes ohmic contact with the semiconductor layer 10b. The low resistance layer 50 has a lower resistivity and a larger thickness than the ohmic metal layer 40. The width in the X and Y directions of the ohmic metal layer 40 included in the source fingers 12a to 12c and drain fingers 16a and 16b may be greater than or equal to the width of the low resistance layer 50 in the X and Y directions. A source wiring 19b connects the source fingers 12a and 12b to each other, and a source wiring 19c connects the source fingers 12a and 12c to each other. Each of the source wirings 19b and 19c is provided on the inactive region 11a, has the low resistance layer 50, and does not have the ohmic metal layer 40. A portion of each of the drain fingers 16a and 16b on the inactive region 11a has the low resistance layer 50 and does not have the ohmic metal layer 40.

Each of the gate fingers 14a to 14d has a gate metal layer 45 on the active region 11 and does not have the low resistance layer 50. The gate wiring 18b has the gate metal layer 45 on the inactive region 11a and does not have the low resistance layer 50. The gate wiring 18a has the gate metal layer 45 and the low resistance layer 50 provided on the semiconductor layer 10b. The low resistance layer 50 has a lower resistivity and a larger thickness than the gate metal layer 45.

The source finger 12a extends in the Y direction and has a width W2a in the X direction and a length L2a in the Y direction. The source fingers 12b and 12c extend in the Y direction from both ends in the X direction of source finger 12a. Each of the source fingers 12b and 12c has a width W2b in the X direction and a length L2b in the Y direction. The drain finger 16a extending in the Y direction is provided at a position separated from the source fingers 12a and 12b by a predetermined distance in a +X direction. The drain finger 16b extending in the Y direction is provided at a position separated from the source fingers 12a and 12c by a predetermined distance in a -X direction. Each of the drain fingers 16a and 16b has a width W6 in the X direction. The gate fingers 14a and 14b are provided between the drain finger 16a and the source fingers 12a and 12b, and the gate fingers 14c and 14d are provided between the drain finger 16b and the source fingers 12a and 12c. Each of the gate fingers 14a to 14d extends in the Y direction, and the width thereof in the X direction corresponds to a gate length Lg.

The gate wiring 18a extending in the Y direction and having a width W8a in the X direction is provided between the source fingers 12b and 12c. The gate wiring 18b is provided between the gate fingers 14a and 14c and the gate fingers 14b and 14d. The gate wiring 18b has a width W8b in the Y direction, extends in the X direction, and connects ends of the gate fingers 14a and 14c in a -Y direction to an end of the gate wiring 18a in a +Y direction. The gate wiring 18b and the source wirings 19b and 19c intersect through the insulating film 26 and are not electrically connected to each other. Ends of gate fingers 14b, 14d and the gate wiring 18a in the -Y direction are connected to the gate bus bar 22. Ends of the drain fingers 16a and 16b in the +Y direction are connected to the drain bus bar 24. The source fingers 12a are connected to the metal layer 28 provided under the substrate 10 through vias 20 that penetrate the substrate 10. The insulating film 26 is provided so as to cover the source fingers 12a to 12c, the gate fingers 14a to 14d, the drain fingers 16a and 16b, and the gate wirings 18a and 18b.

FET regions 30a and 30b are arranged in the Y direction. In the FET region 30a, the active region 11 including the source fingers 12a is extended in the X direction. The source finger 12a, the gate finger 14a, and the drain finger 16a form a unit FET 32a, and the source finger 12a, the gate finger 14c, and the drain finger 16b form a unit FET 32c. A gate width Wga of the unit FETs 32a and 32c corresponds to a length in the Y direction of the active region 11 including the source fingers 12a. A source potential of the unit FETs 32a and 32c is supplied from the metal layer 28 to the source finger 12a through the via 20. A gate potential (and a gate signal) is supplied from the gate bus bar 22 to the gate fingers 14a and 14c through the gate wirings 18a and 18b. A drain potential is supplied from the drain bus bar 24 to the drain fingers 16a and 16b. The unit FETs 32a and 32c are arranged alternately in the X direction.

In the FET region 30b, the active region 11 is provided except for the gate wiring 18a. The source finger 12b, the gate finger 14b and the drain finger 16a form a unit FET 32b, and the source finger 12c, the gate finger 14d and the drain finger 16b form a unit FET 32d. A gate width Wgb of the unit FETs 32b and 32d corresponds to lengths in the Y direction of the active regions 11 including the source fingers 12b and 12c. The source potential of the unit FETs 32b and 32d is supplied from the metal layer 28 to the source fingers 12b and 12c through the via 20 and the source fingers 12a. The gate potential (and the gate signal) is supplied from the gate bus bar 22 to the gate fingers 14b and 14d. The drain potential is supplied from the drain bus bar 24 to the drain fingers 16a and 16b. The unit FETs 32b and 32d are arranged alternately in the X direction. When the gate width of the entire semiconductor device is increased, a plurality of unit FETs 32a to 32d are arranged in the X direction.

If the semiconductor device is, for example, a nitride semiconductor device, the substrate 10a is, for example, a SiC substrate, a silicon substrate, a GaN substrate, or a sapphire substrate. The semiconductor layer 10b includes, for example, nitride semiconductor layers such as GaN, AlGaN and/or InGaN layers. If the semiconductor device is, for example, a GaAs-based semiconductor device, the substrate 10a is, for example, a GaAs substrate. The semiconductor layer 10b includes an arsenide semiconductor layer such as GaAs layer, AlGaAs layer and/or InGaAs layer. The ohmic metal layer 40 is a metal film, and includes, for example, an adhesion film (e.g., titanium) and a low resistance film (e.g., aluminum) having a lower resistivity than the adhesion layer from a side near the substrate 10. The gate metal layer 45 is a metal film, and includes, for example, an adhesion film (e.g., nickel) and a low resistance film (e.g., gold) having a lower resistivity than the adhesion layer from a side near the substrate 10. The low resistance layer 50 is a metal layer, and includes, for example, a barrier layer (e.g., titanium tungsten) and a low resistance layer (e.g., gold) having a lower resistivity than the barrier layer. The source fingers 12a to 12c and the drain fingers 16a and 16b may not include the low resistance layer 50. The gate wiring 18a may not include the gate metal layer 45. The gate bus bar 22 may have the gate metal layer 45 and the low resistance layer 50, or it may have the low resistance layer 50 and no gate metal layer 45. The drain bus bar 24 may have the ohmic metal layer 40 and the low resistance layer 50, or it may have the low resistance layer 50 and no ohmic metal layer 40. The via 20 and the metal layer 28 includes, for example, an adhesion layer and a layer (e.g., gold) having a lower resistivity than the adhesion layer from a side near the substrate 10. The insulating film 26 is, for example, a silicon nitride film.

The width W2a of the source finger 12a in the X direction is, for example, 50 to 100 µm, and the length L2a in the Y direction is, for example, 100 to 400 µm. The width W2b of the source fingers 12b and 12c in the X direction is, is, for example, 5 to 20 µm, and the length L2b in the Y direction is, for example, 110 to 410 µm. The gate length Lg of the gate fingers 14a to 14d in the X direction is, for example, 0.25 to 2 µm. The width W6 of the drain fingers 16a and 16b in the X direction is, for example, 5 to 100 µm. The width W8a of the gate wiring 18a and the width W8b of the gate wiring 18b are, for example, 5 to 20 µm. The gate width Wga of the unit FETs 32a and 32c is, for example, 100 to 400 µm, and the gate width Wgb of the unit FETs 32b and 32d is, for example, 100 to 40 µm. A width W20 of the via 20 is, for example, 10 to 60 µm.

According to the first embodiment, the gate finger 14a (first gate finger) is provided adjacent to the source finger 12a (first source finger) in the X direction (width direction). The width of the source finger 12b (second source finger) is within the width of the source finger 12a and extends in the Y direction (extension direction). The source wiring 19b (first source wiring) connects the source fingers 12a and 12b to each other. The gate finger 14b (second gate finger) is provided adjacent to the source finger 12b in the X direction. The drain finger 16a (the first drain finger) sandwiches the gate fingers 14a and 14b between the drain finger 16a and the source fingers 12a and 12b. The source finger 12a, the gate finger 14a, and the drain finger 16a form the unit FET 32a, and the source finger 12b, the gate finger 14b, and the drain finger 16a form the unit FET 32b. The gate wiring 18b (second gate wiring) intersects the source wiring 19b in a non-contact manner between the gate fingers 14a and 14b, and connects the gate wiring 18a (first gate wiring) to the gate finger 14a. In this case, the source wiring 19b that connects the source fingers 12a and 12b to each other is disposed above the gate wiring 18b, and intersects the gate wiring 18b in the non-contact manner. This is because the source wiring 19b intersects the gate wiring 18b through the insulating film 26. This allows the gate potential to be supplied to gate finger 14a via gate wirings 18a and 18b. Therefore, the gate resistance of the unit FET 32a can be lowered.

The width W2a in the X direction of the source finger 12a may be designed to be wide. For example, a source inductance can be reduced by supplying the source potential to the source finger 12a by the via 20. However, the width W2a of the source finger 12a becomes wider. On the other hand, the width Wb2 in the Y direction of the source fingers 12b and 12c to supply the source potential need not be as wide as the width W2a. Therefore, the gate wiring 18a is provided so as to sandwich the source finger 12b between the gate wiring 18a and the gate finger 14b. Thereby, the gate wiring 18a and the source fingers 12b do not overlap with each other in plan view. Therefore, a gate-source capacitance can be suppressed. In addition, the width W2b of the source finger 12b and the width W8a of the gate wiring 1 8a in the Y direction are smaller than the width W2a. When viewed from the Y direction, the gate wiring 18a is installed so that the width W8a of the gate wiring 18a is within the width W2a of the source finger 12a. In other words, when viewed from the Y direction, the gate wiring 18a and the source fingers 12b and 12c overlap with the source finger 12a and do not overlap with regions other than source finger 12a. As a result, the width of the semiconductor device in the X direction can be suppressed even if gate wiring 18a is provided. Therefore, the semiconductor device can be reduced in size.

The gate finger 14c (third gate finger) sandwiches the source finger 12a between the gate finger 14a and the gate finger 14c. The source finger 12c (third source finger) has the width W2b that is smaller than the width W2a, extends in the Y direction. The width in the X direction of the source finger 12c is within the width of the source finger 12a. The source finger 12c is adjacent to the gate wiring 18a and sandwiches the gate wiring 18a between the source finger 12b and the source finger 12c. The source wiring 19c (second source wiring) connects the source fingers 12a and 12c to each other. The gate finger 14d (fourth gate finger) sandwiches the source finger 12c between the gate wiring 18a and the gate finger 14d, and extends in the Y direction. The drain finger 16b (second drain finger) sandwiches the gate fingers 14c and 14d between the drain finger 16b and the source fingers 12a and 12c. The gate wiring 18b intersects the source wiring 19c in the non-contact manner between the gate fingers 14c and 14d, and connects the gate wiring 18a to the gate fingers 14c. In this case, the source wiring 19c that connects the source fingers 12a and 12c to each other is disposed above the gate wiring 18b, and intersects the gate wiring 18b in the non-contact manner. This is because the source wiring 19c intersects the gate wiring 18b through the insulating film 26. As a result, the source finger 12a, the gate finger 14c and the drain finger 16b form the unit FET 32c, and the source finger 12c, the gate finger 14d and the drain finger 16b form the unit FET 32d.

The via 20 penetrates the substrate 10 and connects the source fingers 12a to the metal layer 28 under the substrate 10. In this way, when the via 20 is connected directly to the source fingers 12a, the width W2a of the source fingers 12a becomes wider. Therefore, the gate wiring 18a can be provided between the source fingers 12b and 12c.

The gate bus bar 22 is provided opposite to the source fingers 12a with respect to the source fingers 12b and 12c, and is connected to the gate wiring 18a. This allows the gate potential to be supplied from the gate bus bar 22 to the gate wiring 18a.

First ends of the gate fingers 14b and 14d are connected to the gate bus bar 22, and second ends of the gate fingers 14b and 14d are separated from the gate wiring 18b. This causes a phase difference between the gate signals supplied from gate bus bar 22 to the gate fingers 14b and 14d and the gate signals supplied from the gate wirings 18a and 18b to the gate fingers 14a and 14c. However, the gate signals are supplied to the gate fingers 14a to 14d from the -Y direction, and signals are output from the drain fingers 16a and 16b in the +Y direction. This can suppress a loss due to the phase difference. Therefore, the high-frequency characteristics can be improved.

### (FIRST VARIATION OF FIRST EMBODIMENT)

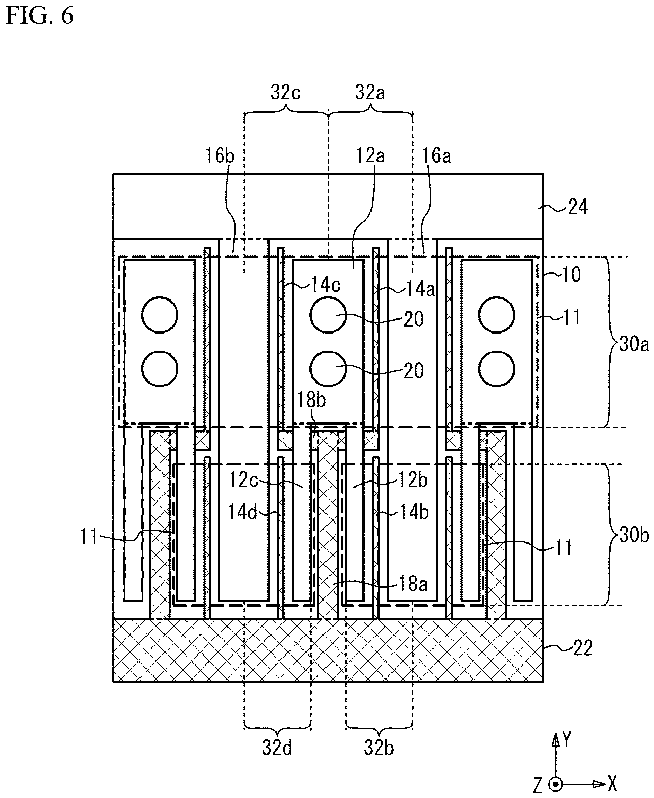

FIG. 6 is a plan view illustrating a semiconductor device according to a first variation of the first embodiment. As illustrated in FIG. 6, in the first variation of the first embodiment, two vias 20 are provided in one source finger 12a. In this way, the source inductance can be further reduced by providing a plurality of vias 20 in one source finger 12a. Other configurations of the first variation of the first embodiment are the same as those of the first embodiment, and the description thereof will be omitted.

### (SECOND VARIATION OF FIRST EMBODIMENT)

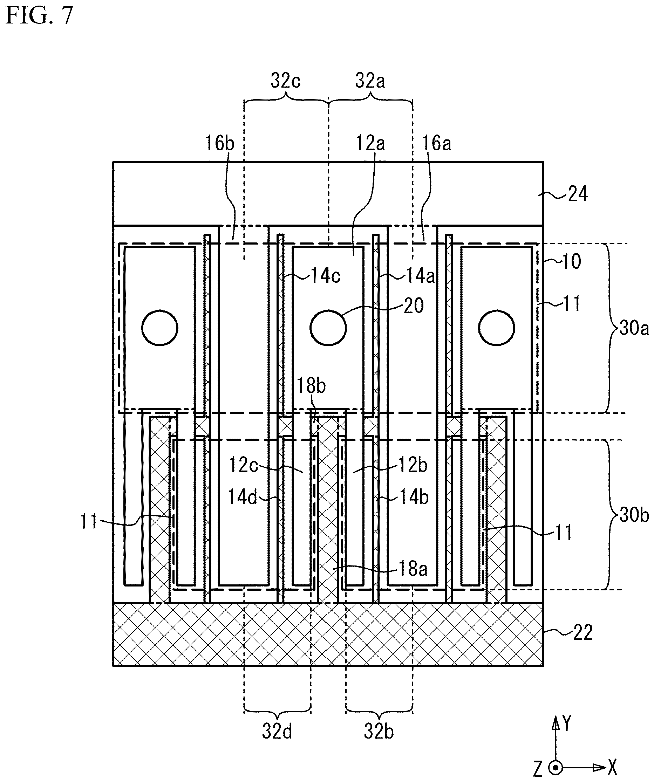

FIG. 7 is a plan view illustrating a semiconductor device according to a second variation of the first embodiment. As illustrated in FIG. 7, in the second variation of the first embodiment, the first ends in the -Y direction of the gate fingers 14b and 14d are connected to the gate bus bar 22, and the second ends in the +Y direction of the gate fingers 14b and 14d are connected to the gate wiring 18b. Thereby, the gate potential is supplied to the gate fingers 14b and 14d from the ±Y direction. Therefore, the gate resistance in the unit FETs 32b and 32d can be further suppressed. In addition, the gate width Wgb of the unit FETs 32b and 32d can also be made larger. Other configurations of the second variation of the first embodiment are the same as those of the first embodiment, and the description thereof will be omitted.

### (THIRD VARIATION OF FIRST EMBODIMENT)

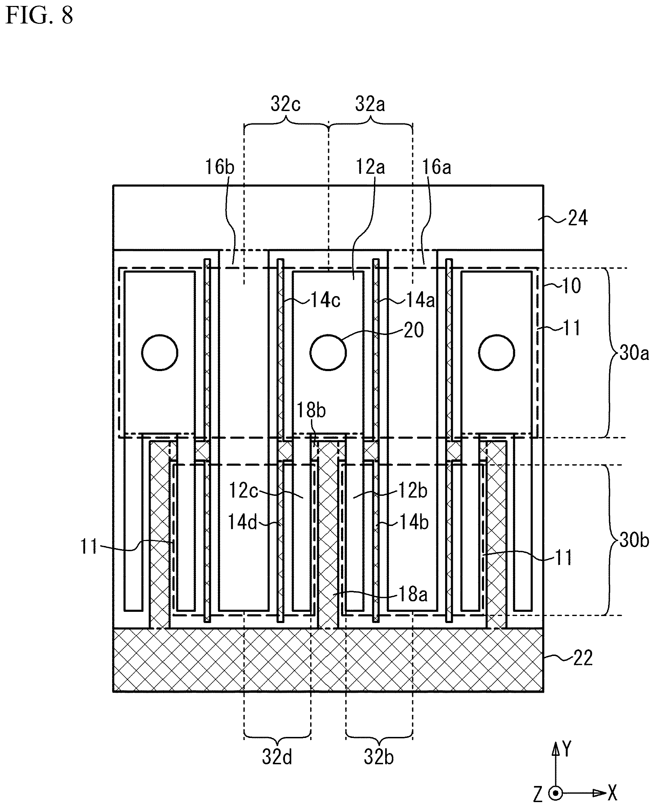

FIG. 8 is a plan view illustrating a semiconductor device according to a third variation of the first embodiment. As illustrated in FIG. 8, in the third variation of the first embodiment, the first ends in the -Y direction of the gate fingers 14b and 14d are separated from the gate bus bar 22, and the second ends in the +Y direction of the gate fingers 14b and 14d are connected to the gate wiring 18b. Thereby, the unit FET 32a and the unit FET 32b can be made symmetrical with each other, and the unit FET 32c and the unit 32d can be made symmetrical with each other. Therefore, the phases of the gate signals supplied to the unit FETs 32a to 32d are aligned, and hence the high-frequency characteristics can be improved. Other configurations of the third variation of the first embodiment are the same as those of the first embodiment, and the description thereof will be omitted.

### (SECOND EMBODIMENT)

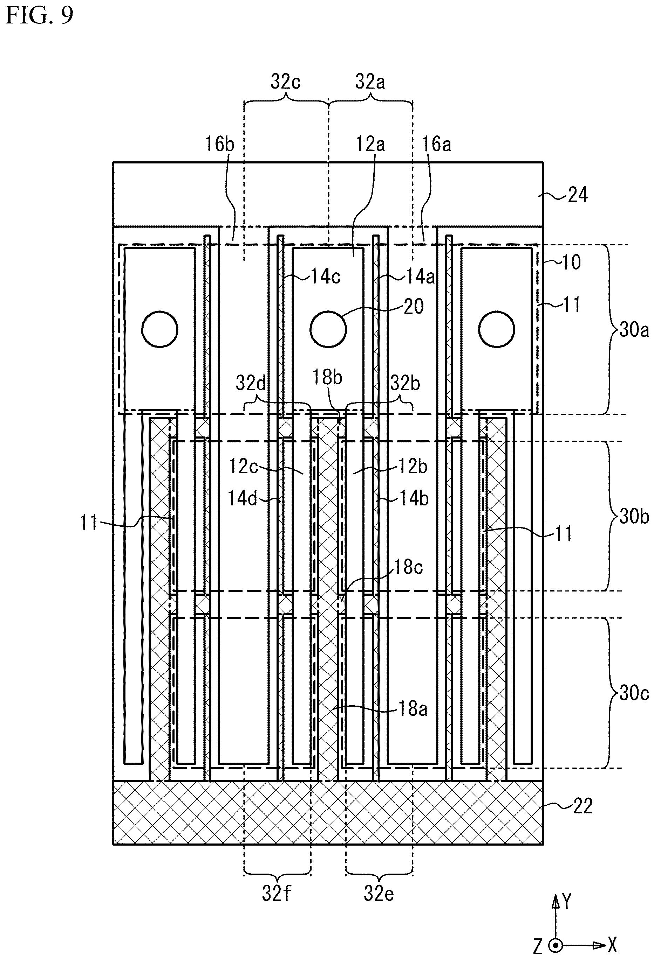

FIG. 9 is a plan view illustrating a semiconductor device according to a second embodiment. As illustrated in FIG. 9, in the second embodiment, three FET regions 30a to 30c are provided in the Y direction. A gate wiring 18c connecting the gate fingers 14b and 14d to the gate wiring 18a is provided between the FET regions 30b and 30c. The gate wiring 18c is provided between the active regions 11. In the FET region 30c, the source finger 12b, the gate finger 14b and the drain finger 16a form a unit FET 32e, and the source finger 12c, the gate finger 14d and the drain finger 16b form a unit FET 32f. As in the second embodiment, the gate wiring 18c that supplies the gate potential to the gate fingers 14b and 14d may be provided. Thereby, three or more FET regions 30a to 30c can be provided in the Y direction. Other configurations of the second embodiment are the same as those of the third variation of the first embodiment, and the description thereof will be omitted.

### (FIRST VARIATION OF SECOND EMBODIMENT)

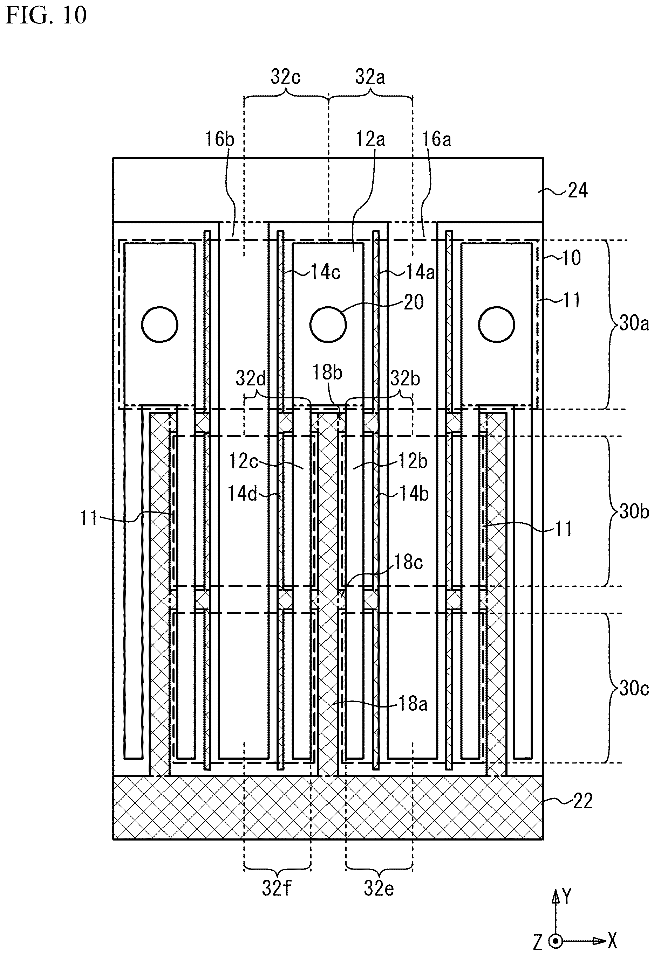

FIG. 10 is a plan view illustrating a semiconductor device according to a first variation of the second embodiment. As illustrated in FIG. 10, in the first variation of the second embodiment, the gate fingers 14b and 14d are not connected to the gate bus bar 22. Other configurations of the first variation of the second embodiment are the same as those of the second embodiment, and the description thereof will be omitted. If the gate potential can be supplied to the gate fingers 14a to 14d of the unit FETs 32a to 32f, the connection or non-connection between the gate fingers 14b and 14d, and the gate wiring 18b and 18c and the gate bus bar 22 can be designed accordingly.

### (EXPERIMENT)

GaN-based HEMTs (High Electron Mobility Transistor) were fabricated. The following four types of samples were fabricated. Each of samples A and B is a comparative example having one FET region.
Sample A: two Unit FETs with gate width of 440 µm
Sample B: two Unit FETs with gate width of 380 µm
   A sample C is an example in which the gate wiring connecting the gate fingers 14b and 14d to the gate wiring 18a is provided, and four unit FETs are provided in the Y direction, in addition to the second embodiment.
Sample C: The total of gate widths of four unit FETs arranged in the Y direction is 440 µm × 2
   A sample D is the first variation of the second embodiment.
Sample D: The total of gate widths of two unit FETs arranged in the Y direction is 380 µm × 2

Linear gains were measured for the samples A to D. The measurement conditions are as follows: a frequency is 4.8 GHz, a drain bias voltage is 50 V, and a drain bias current is 8 mA/mm. The linear gains of the samples C and D were improved by 1 dB or more as compared with the samples A and B, respectively. It is considered that this is because the gate resistances of the samples C and D were lower than those of the samples A and B. In the samples C and D, the gate wiring does not overlap with the source fingers, and hence the degradation of high-frequency characteristics caused by the increase in gate-source capacitance is suppressed.

### (SECOND VARIATION OF SECOND EMBODIMENT)

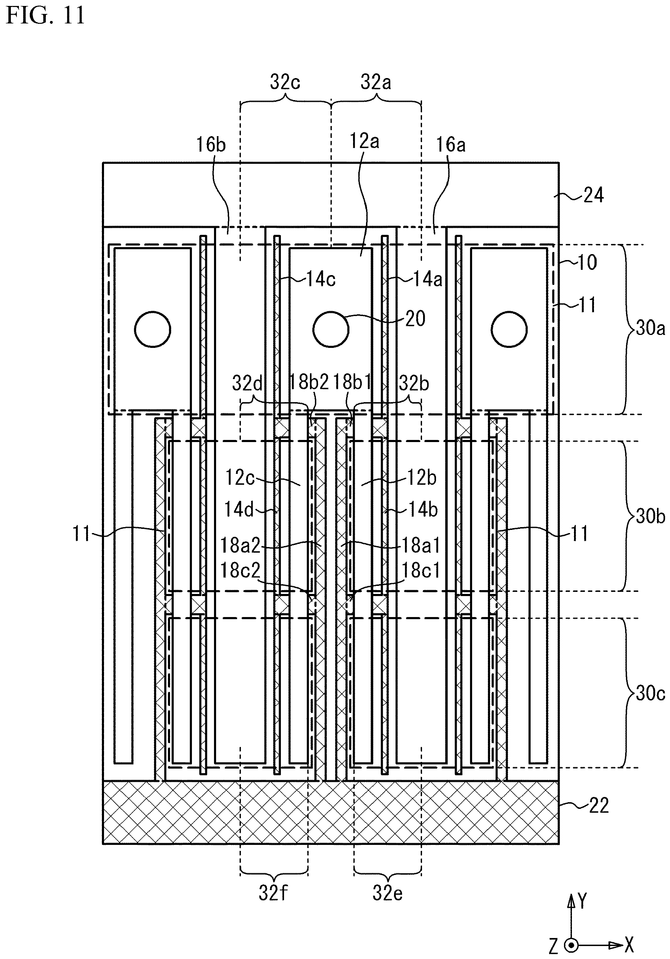

FIG. 11 is a plan view illustrating a semiconductor device according to a second variation of the second embodiment. As illustrated in FIG. 11, in the second variation of the second embodiment, the gate wiring 18a is divided into gate wirings 18a1 and 18a2, and the gate wiring 18b is divided into gate wirings 18b1 and 18b2, and the gate wiring 18c is divided into gate wirings 18c1 and 18c2. The gate wirings 18b1 and 18c1 connect the gate finger 14b to the gate wiring 18a1, and the gate wirings 18b2 and 18c2 connect the gate finger 14d to the gate wiring 18a2. The gate wirings 18a1, 18b1, and 18c1 are not connected to the gate wirings 18a2, 18b2, and 18c2 on the substrate 10. Other configurations of the second variation of the second embodiment are the same as those of the first variation of the second embodiment, and the description thereof will be omitted.

According to the second variant of the second embodiment, the gate wiring 18a2 (third gate wiring) is provided between the source finger 12c and the gate wiring 18a1 (first gate wiring), and the width in the X direction of the gate wiring 18a2 is within the width of source finger 12a, and is separated from the gate wiring 18a1 on the substrate 10. The gate wiring 18b2 (fourth gate wiring) intersects the source wiring 19c in the non-contact manner, is separated from the gate wiring 18b 1 (second gate wiring) on the substrate 10, and connects the gate wiring 18a2 to the gate fingers 14c. As a result, a high-frequency signal transmitted to the gate finger 14a and a high-frequency signal transmitted to the gate finger 14b are separated in the gate wiring 18a. Therefore, oscillation can be suppressed. In the first embodiment and its variations as well as in the second embodiment, the gate wirings 18a and 18b may be divided as in the second variation of the second embodiment.

### (THIRD VARIATION OF SECOND EMBODIMENT)

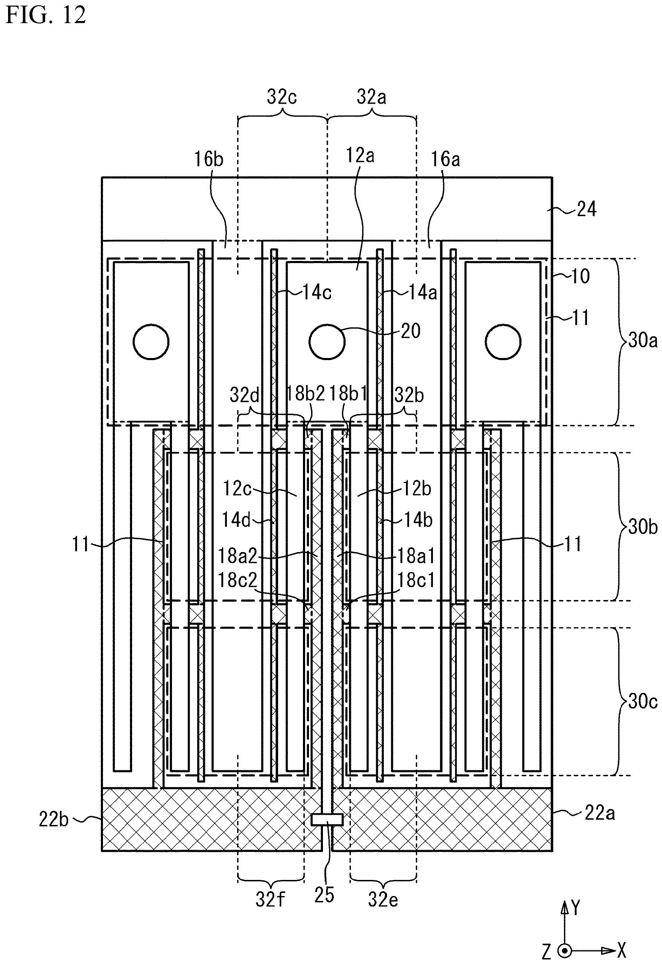

FIG. 12 is a plan view illustrating a semiconductor device according to a third variation of the second embodiment. As illustrated in FIG. 12, in the third variant of the second embodiment, the gate bus bar 22 is divided into gate bus bars 22a and 22b. The gate bus bars 22a and 22b are connected via a resistor 25. The resistor 25 is, for example, a semiconductor resistor using the semiconductor layer 10b, a metallic resistor using metal with a high resistivity such as nickel-chromium alloys, tantalum or tungsten, or a metallic resistor using the ohmic metal layer 40, the gate metal layer 45 or the low resistance layer 50, such as gold or aluminum, and a thin wiring. Other configurations of the third variation of the second embodiment are the same as those of the second variation of the second embodiment, and the description thereof will be omitted.

### (FOURTH VARIATION OF SECOND EMBODIMENT)

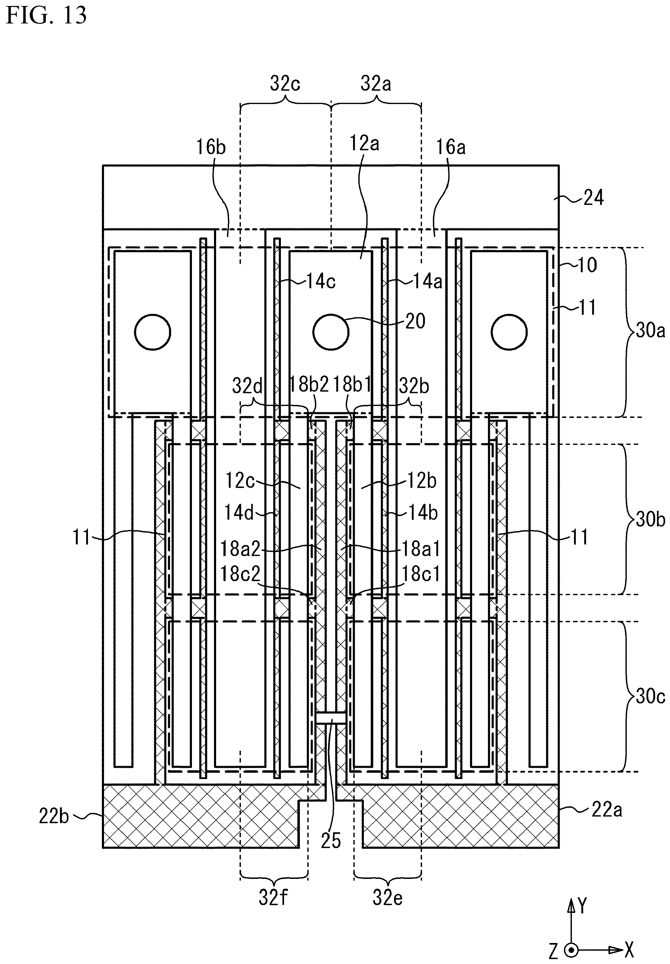

FIG. 12 is a plan view illustrating a semiconductor device according to a fourth variation of the second embodiment. As illustrated in FIG. 13, in the fourth variation of the second embodiment, the gate wirings 18a1 and 18a2 are connected via the resistor 25. The gate bus bars 22a and 22b are more separated compared with the third variation of the second embodiment. Other configurations of the fourth variation of the second embodiment are the same as those of the third variation of the second embodiment, and the description thereof will be omitted.

As illustrated in the third and the fourth variations of the second embodiment, the gate bus bar 22a (first gate bus bar) connected to the gate wiring 18a1 and the gate bus bar 22b (second gate bus bar) connected to the gate wiring 18a2 are separated on the substrate 10. The resistor 25 is provided to electrically connect the gate wiring 18a1 and the gate bus bar 22a to the gate wiring 18a2 and gate bus bar 22b. Thereby, the high-frequency signal transmitted to the gate finger 14a and the high-frequency signal transmitted to the gate finger 14b are separated in the gate wiring 18a and the gate bus bar 22. Therefore, oscillation can be suppressed compared with the second variation of the second embodiment. By adding the resistor 25, the signal transmitted through the loop in the FET is attenuated and oscillation can be further suppressed. In the first embodiment and its variations as well as in the second embodiment, the gate bus bar 22 may be divided and the resistor 25 may be provided as in the third and the fourth variations of the second embodiment.

### (THIRD EMBODIMENT)

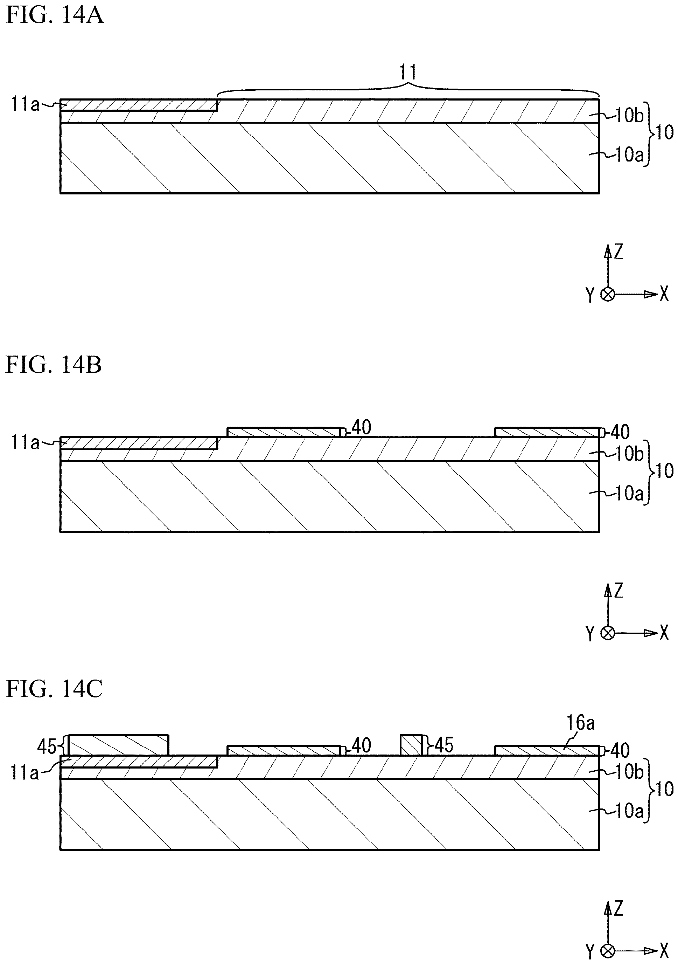

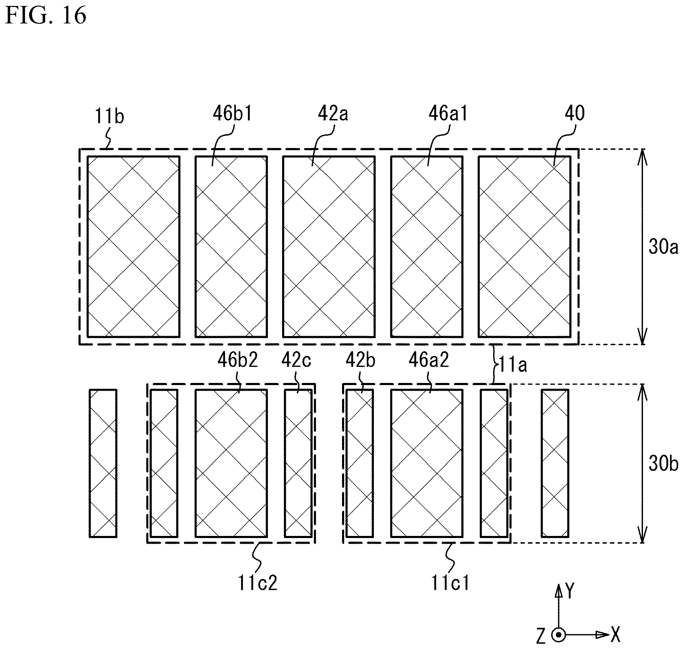

A third embodiment is an example of a manufacturing method according to the first and the second embodiments and their variations. FIGs. 14A to 15C are cross-sectional views illustrating a method for manufacturing a semiconductor device according to the third embodiment. FIGs. 16 to 18 are plan views illustrating a method for manufacturing the semiconductor device according to the third embodiment. As illustrated in FIG. 14a, the inactive region 11a is formed in the semiconductor layer 10b by ion implantation. A region where the inactive region 11a is not formed is the active region 11.

As illustrated in FIG. 16, the active region 11b is formed in the FET region 30a, and the active regions 11c1 and 11c2 are formed in the FET region 30b. One bandshaped active region 11b extending in the X direction is formed in the FET 30a. The plurality of active regions 11c1 and 11c2 aligned in the X direction are formed in the FET region 30b. A region between the active region 11b and the active regions 11c1 and 11c2 is the inactive region 11a, and a region between the active regions 11c1 and 11c2 is the inactive region 11a.

As illustrated in FIG. 14b and FIG. 16, the ohmic metal layers 40 are formed on the active regions 11b and 11c. For example, a vacuum deposition method and a lift-off method are used to form the ohmic metal layers 40. A source ohmic layer 42a and drain ohmic layers 46a1 and 46b1 are formed on the active region 11b. A source ohmic layer 42b and a drain ohmic layer 46a2 are formed on the active region 11c1. A source ohmic layer 42c and a drain ohmic layer 46b2 are formed on the active region 11c2. Then, heat treatment is performed. Thereby, the source ohmic layer 42a and the drain ohmic layers 46a1 and 46b1 make ohmic contact with the active region 11b. The source ohmic layer 42b and the drain ohmic layer 46a2 make ohmic contact with the active region 11c1. The source ohmic layer 42c and the drain ohmic layer 46b2 make ohmic contact with the active region 11c2.

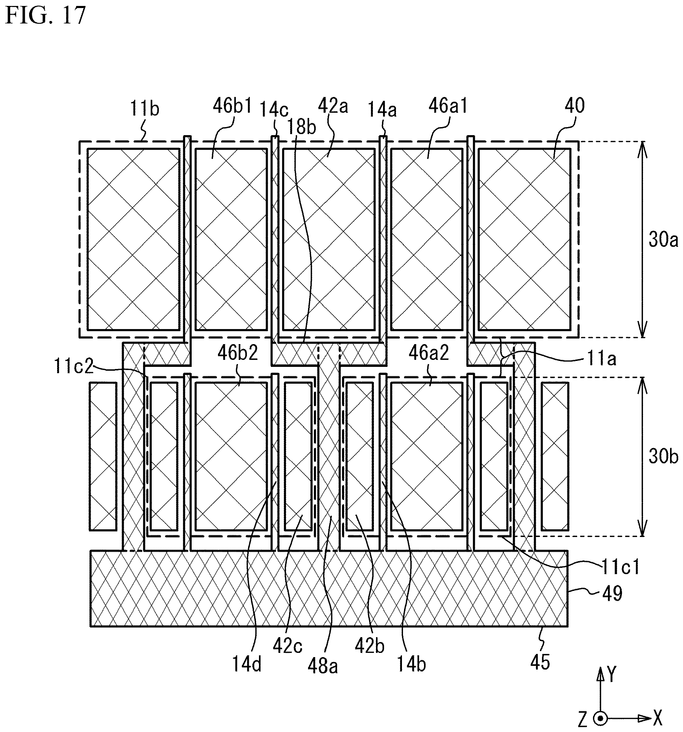

As illustrated in FIG. 14c and FIG. 17, the gate metal layer 45 is formed on the substrate 10. For example, the vacuum deposition method and the lift-off method are used to form the gate metal layer 45. The gate finger 14a is formed on the active region 11b between the source ohmic layer 42a and the drain ohmic layer 46a1, and the gate finger 14c is formed on the active region 11b between the source ohmic layer 42a and the drain ohmic layer 46b1. The gate finger 14b is formed on the active region 11c1 between the source ohmic layer 42b and the drain ohmic layer 46a2. The gate finger 14d is formed on the active region 11c2 between the source ohmic layer 42c and the drain ohmic layer 46b2. The gate wiring 18b is formed on the inactive region 11a between the active region 11b and the active regions 11c1 and 11c2.The gate metal layer 48a is formed on the inactive region 11a between the active regions 11c1 and 11c2. A gate metal layer 49 connected to gate fingers 14b, 14d and gate metal layer 48a is formed on the -Y side of the FET region 30b.

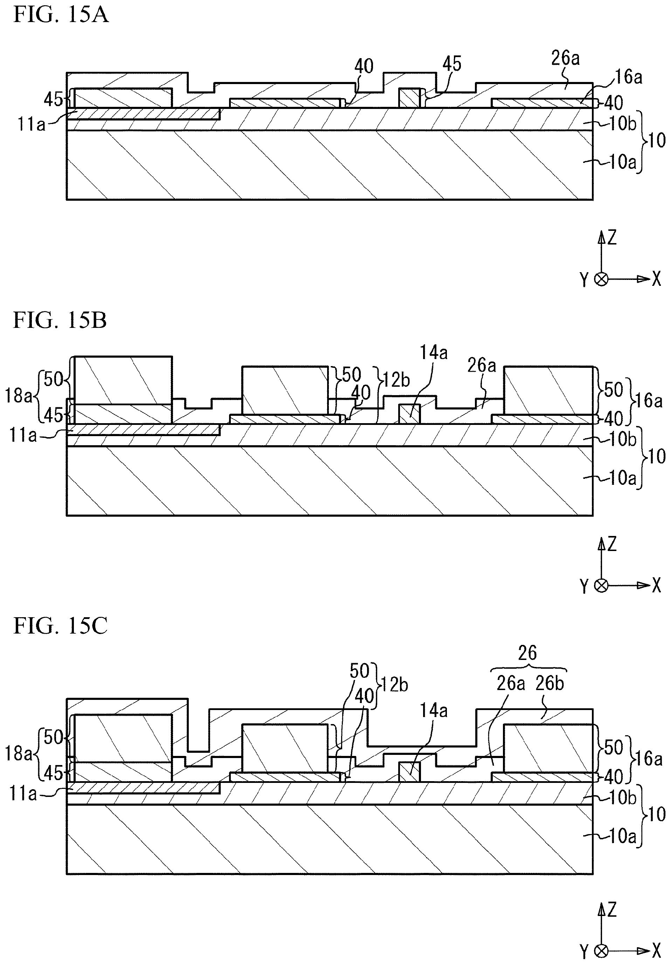

As illustrated in FIG. 15A, an insulating film 26a is formed on the substrate 10 to cover the ohmic metal layer 40 and the gate metal layer 45. The insulating film 26a is formed using, for example, a CVD (Chemical Vapor Deposition) method.

As illustrated in FIG. 15b, openings are formed in desired regions of the insulating film 26a using an etching method. The low resistance layer 50 is formed in the openings and on the insulating film 26a. For example, the plating method is used to form the low resistance layer 50.

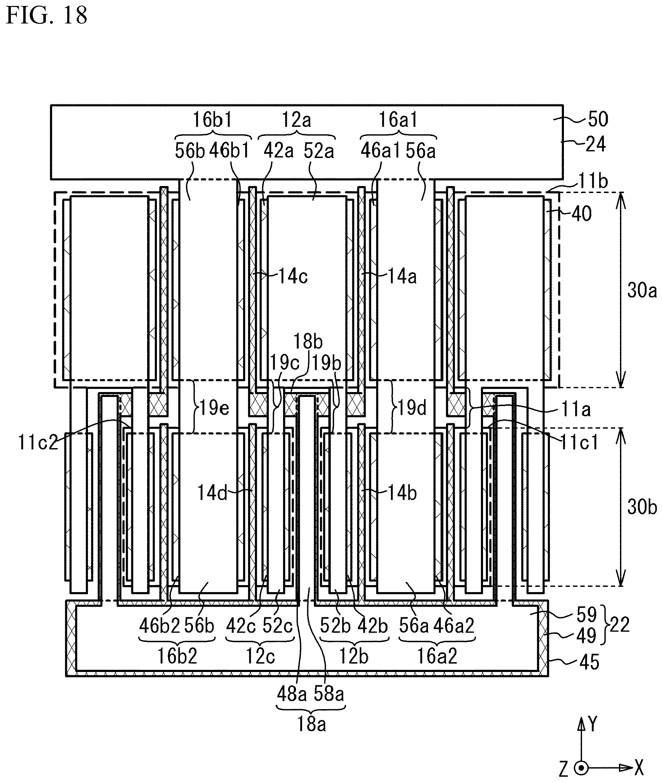

As illustrated in FIG. 15b and FIG. 18, the low resistance layer 50 is formed on the ohmic metal layer 40 and the gate metal layer 45. The sheet resistance of the low resistance layer 50 is lower than the sheet resistance of the ohmic metal layer 40 and the gate metal layer 45. The source finger 12a is formed of the source ohmic layer 42a and a source low resistance layer 52a formed on the source ohmic layer 42a. A drain finger 16a1 is formed of the drain ohmic layer 46a1 and a drain low resistance layer 56a formed on the drain ohmic layer 46a1. A drain finger 16b1 is formed of the drain ohmic layer 46b1 and a drain low resistance layer 56b formed on the drain ohmic layer 46b1.

The source finger 12b is formed of the source ohmic layer 42b and a source low resistance layer 52b formed on the source ohmic layer 42b. The source finger 12c is formed of the source ohmic layer 42c and a source low resistance layer 52c formed on the source ohmic layer 42c. A drain finger 16a2 is formed of the drain ohmic layer 46a2 and the drain low resistance layer 56a formed on the drain ohmic layer 46a2. A drain finger 16b2 is formed of the drain ohmic layer 46b2 and the drain low resistance layer 56b formed on the drain ohmic layer 46b2.

Drain wirings 19d and 19e are formed by the drain low resistance layers 56a and 56b formed on the inactive region 11a, respectively. The drain finger 16a1, the drain wiring 19d, and the drain finger 16a2 form the drain finger 16a of the first embodiment. The drain finger 16b1, the drain wiring 19e, and drain finger 16b2 form the drain finger 16b of the first embodiment. The drain bus bar 24 connected to the drain low resistance layers 56a and 56b is formed on the +Y side of the FET region 30a.

The gate metal layer 48a and a low resistance layer 58a formed on the gate metal layer 48a form the gate wiring 18a. A low resistance layer 59 connected to the low resistance layer 58a is formed on the gate metal layer 49. The gate metal layer 49 and the low resistance layer 59 form the gate bus bar 22.

As illustrated in FIG. 15C, an insulating film 26b is formed on the insulating film 26a to cover the low resistance layer 50. For example, the CVD method is used to form the insulating film 26b. The insulating films 26a and 26b form the insulating film 26. Then, the vias 20 are formed on the substrate 10, and the metal layer 28 is formed inside the vias 20 and on the bottom surface of the substrate 10. Thereby, the semiconductor device according to the first embodiment is manufactured.

In the third embodiment, since the gate wiring 18a is formed of the gate metal layer 45 and the low resistance layer 50, the resistance of the gate wiring 18a can be reduced. Since the source fingers 12a to 12c, and the drain fingers 16a1, 16a2, 16b1 and 16b2 can be formed of the ohmic metal layer 40 and the low resistance layer 50, the resistance of the source fingers 12a to 12c and the drain fingers 16a1, 16a2, 16b1 and 16b2 can be reduced. The source wiring 19b and 19c are formed of the low resistance layer 50, and the gate wiring 18b is formed of the gate metal layer 45. Therefore, the source wirings 19b and 19c can intersect the gate metal layer 45 in the non-contact manner through the insulating film 26a. Since the gate wirings 18a and 18b are formed on the inactive region 11a, a gate parasitic capacitance can be suppressed.

According to the third embodiment and its variations, as illustrated in FIGs. 14a and 16, the active region 11b (first active region) and the active region 11c1 (second active region) which are separated from each other and in which the semiconductor layer 10b is activated, and the inactive region 11a which is provided between the active regions 11b and 11c1 and in which the semiconductor layer 10b is deactivated, are formed in the substrate 10.

As illustrated in FIG. 16, the source ohmic layer 42a (first source ohmic layer) and the drain ohmic layer 46a1 (first drain ohmic layer) are formed on the active region 11b. The source ohmic layer 42b (second source ohmic layer) and the drain ohmic layer 46a2 (second drain ohmic layer) are formed on the active region 11c1.

As illustrated in FIG. 17, the gate fingers 14a (first gate fingers) is formed on the active region 11b. The gate finger 14b (second gate finger) is formed on the active region 11c1. The gate metal layer 48a which is a layer of a part of the gate wiring 18a (first gate wiring) is formed on the inactive region 11a. The gate wiring 18b (second gate wiring) is formed on the inactive region 11a.

As illustrated in FIG. 18, the source low resistance layer 52a (first source low resistance layer) in contact with the source ohmic layer 42a, and the source low resistance layer 52b (second source low resistance layer) in contact with the source ohmic layer 42b are formed, and the source wiring 19b, which connects the source low resistance layer 52a and 52b to each other and intersects the gate wiring 18b in the non-contact manner, is formed on the inactive region 11a at the same time as the source low resistance layers 52a and 52b. Thereby, the source wiring 19b is continuous with the source low resistance layers 52a and 52b and is formed of the same material as the source low resistance layers 52a and 52b.

The source wiring 19b is continuous with the source low resistance layers 52a and 52b and is formed of the same material as the source low resistance layers 52a and 52b. The sheet resistance of the source low resistance layers 52a and 52b is lower than the sheet resistance of the source ohmic layers 42a and 42b. This makes it possible to lower the resistance between the source fingers 12a and 12b and to intersect the gate wiring 18b and the source wiring 19b in the non-contact manner.

The drain finger 16a has the drain ohmic layer 46a1 (first drain ohmic layer), the drain ohmic layer 46a2 (second drain ohmic layer), and the drain low resistance layer 5 6a. The drain low resistance layer 56a is in contact with the drain ohmic layers 46a1 and 46a2 and the sheet resistance of the drain low resistance layer 56a is lower than the sheet resistance of the drain ohmic layers 46a1 and 46a2. This makes it possible to lower the resistance of the drain finger 16a.

The sheet resistance of the low resistance layer 50 is preferably 1/2 or less, more preferably 1/5 or less, still more preferably 1/10 or less of the sheet resistance of the ohmic metal layer 40. A method to make the sheet resistance of the low resistance layer 50 smaller than that of the ohmic metal layer 40 is to make the resistivity of the main metal layer (e.g., gold) of the low resistance layer 50 lower than that of the main metal layer (e.g., aluminum) of the ohmic metal layer 40. Another method is to make the low resistance layer 50 thicker than the ohmic metal layer 40.

The gate wiring 18b is formed at the same time as the gate fingers 14a and 14b. In other words, the material and the thickness of the gate wiring 18b are the same as those of the gate fingers 14a and 14b. This simplifies the manufacturing process.

At least a part of the gate wiring 18a (gate metal layer 48a) is formed at the same time as the gate wiring 18b. In other words, the material and the thickness of the gate metal layer 48a are the same as the material and the thickness of the gate wiring 18b. This simplifies the manufacturing process.

### (FIRST VARIATION OF THIRD EMBODIMENT)

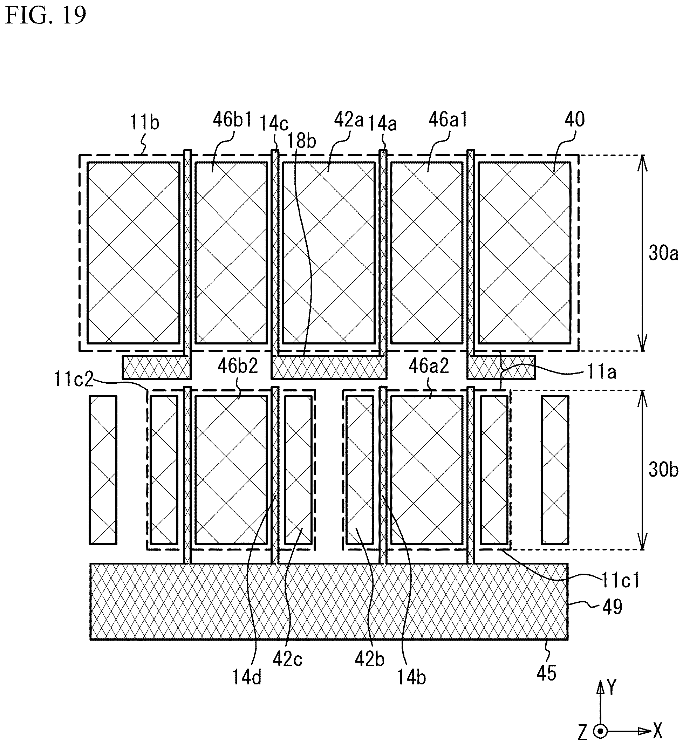

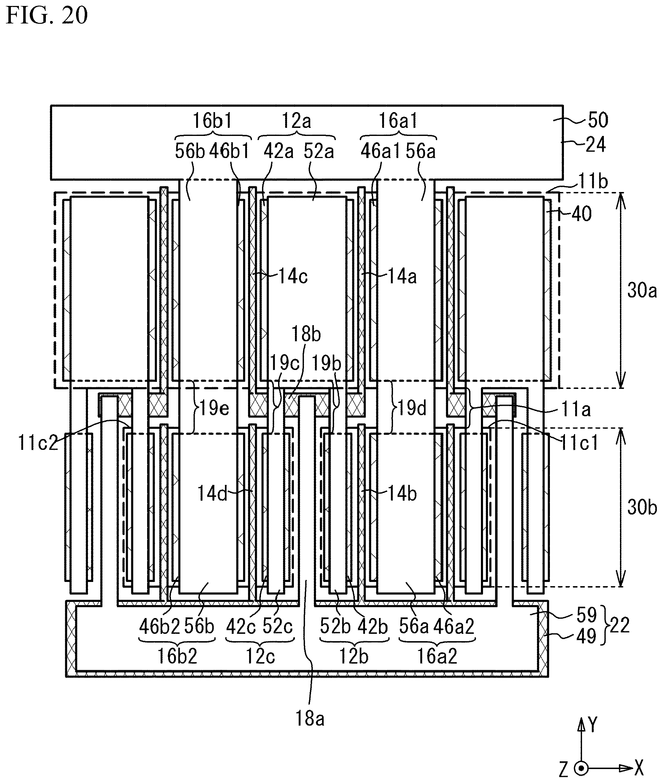

FIGs. 19 and 20 are plan views illustrating a semiconductor device according to a first variation of the third embodiment. As illustrated in FIG. 19, the gate metal layer 48a is not formed when the gate metal layer 45 is formed.

As illustrated in FIG. 20, the gate wiring 18a is formed of the low resistance layer 50 and does not have the gate metal layer 45. Other processes of the first variation of the third embodiment are the same as those of the third embodiment, and the description thereof will be omitted.

Since the gate wiring 18a has the low resistance layer 58a, the resistance can be sufficiently reduced. Therefore, the gate wiring 18a does not need to have the gate metal layer 48a.

### (SECOND VARIATION OF THIRD EMBODIMENT)

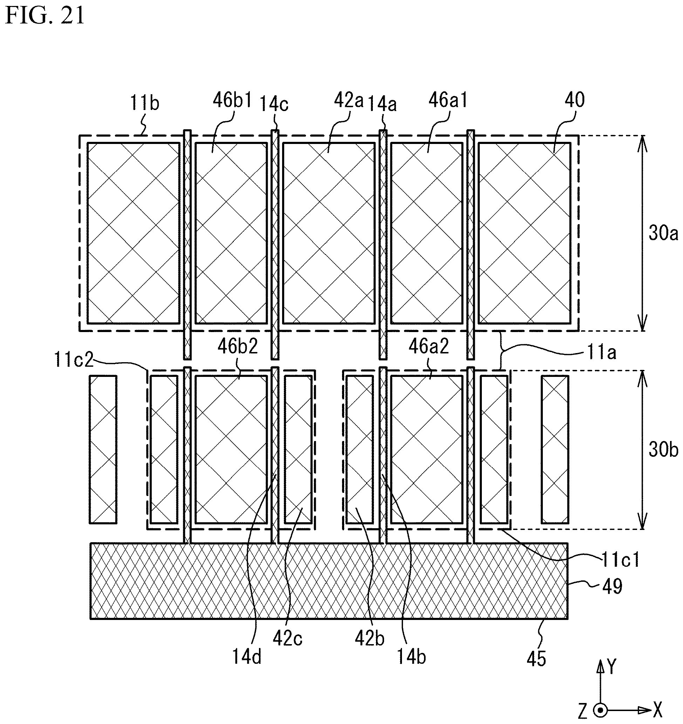

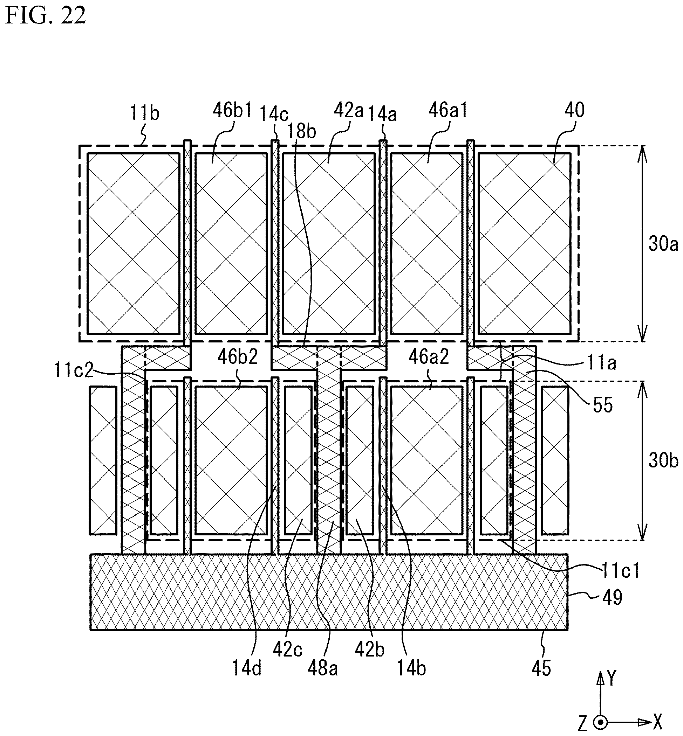

FIGs. 21 and 22 are plan views illustrating a semiconductor device according to a second variation of the third embodiment. As illustrated in FIG. 21, the gate wiring 18b and the gate metal layer 48a are not formed when the gate metal layer 45 is formed.

As illustrated in FIG. 22, a gate metal layer 55 is formed on the inactive region 11a. For example, the vacuum deposition method and the lift-off method are used to form the gate metal layer 55. The gate metal layer 55 forms the gate wiring 18b and the gate metal layer 48a. The gate metal layer 55 is made of a material having a lower resistivity than the gate metal layer 45. For example, if gold is used for the gate metal layer 45, silver or copper is used for the gate metal layer 55. Also, the gate metal layer 55 is made thicker than the gate metal layer 45. This allows the sheet resistance of the gate metal layer 55 to be lower than the sheet resistance of the gate metal layer 45. Therefore, in the second variation of the third embodiment, the resistance of the gate wirings 18a and 18b can be reduced. Other processes of the second variation of the third embodiment are the same as those of the third embodiment, and the description thereof will be omitted.

### (THIRD VARIATION OF THIRD EMBODIMENT)

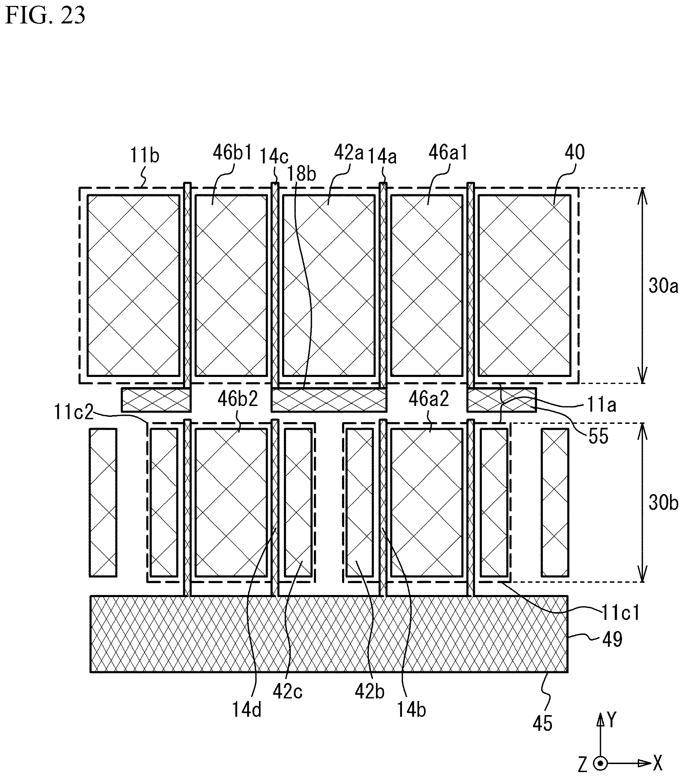

FIG. 23 is a plan view illustrating a semiconductor device according to a third variation of the third embodiment. As illustrated in FIG. 23, the gate metal layer 55 has the gate wiring 18b and does not have to have the gate metal layer 48a. Other processes of the third variation of the third embodiment are the same as those of the second variation of the third embodiment, and the description thereof will be omitted. As in the third variation of the third embodiment, the gate wiring 18b intersects the source wirings 19b and 19c, and therefore the low resistance layer 50 cannot be provided. For this reason, the gate wiring 18b is formed of the gate metal layer 55. Since the gate wiring 18a has the low resistance layer 50, the resistance of the gate wiring 18a can be sufficiently reduced. For this reason, the gate wiring 18a does not have to have the gate metal layer 48a.

According to the second and the third variations of the third embodiment, the sheet resistance of the gate wiring 18b is lower than the sheet resistance of the gate fingers 14a and 14b. This makes it possible to lower the resistance of the gate wiring 18b. The sheet resistance of the gate wiring 18b is preferably 1/2 or less, more preferably 1/5 or less of the sheet resistance of the gate fingers 14a and 14b. A method to make the sheet resistance of gate wiring 18b smaller than that of gate fingers 14a and 14b is to make the resistivity of the main metal layer (e.g., silver or copper) of the gate wiring 18b lower than that of the main metal layer (e.g., gold) of the gate fingers 14a and 14b. Another method is to make the gate wiring 18b thicker than the gate fingers 14a and 14b.

In the first to third embodiments and their variations, an example where four unit FETs are arranged in the X direction has been described. However, the number of unit FETs in the X direction may be one, two, three, or five or more. If four unit FETs arranged in the X direction are considered as one group, a plurality of groups may be arranged in the X direction.

In this disclosure, the phrase "provided on the substrate" includes both of a case where an object is in contact with the substrate and a case where the object is provided on the substrate via another object.

The embodiments disclosed here should be considered illustrative in all respects and not restrictive. The present disclosure is not limited to the specific embodiments described above, but various variations and changes are possible within the scope of the gist of the present disclosure as described in the claims.

## Claims

1. A semiconductor device comprising:
a substrate;
a first source finger provided on the substrate;
a first gate finger provided on the substrate, along the first source finger, and adjacent to the first source finger in a width direction of the first source finger;
a second source finger provided on the substrate, having a width smaller than a width of the first source finger, and extending in an extension direction of the first source finger, the width of the second source finger in the width direction being within the width of the first source finger;
a second gate finger provided on the substrate and adjacent to the second source finger in the width direction of the second source finger, the second gate finger extending in an extension direction of the first gate finger;
a first source wiring provided on the substrate and connecting the first source finger to the second source finger;
a first gate wiring provided on the substrate and sandwiching the second source finger between the first gate wiring and the second gate finger, the width of the first gate wiring in the width direction being within the width of the first source finger;
a second gate wiring provided on the substrate, intersecting the first source wiring in a non-contact manner, and connecting the first gate wiring to the first gate finger; and
a first drain finger provided on the substrate and sandwiching the first gate finger and the second gate finger between the first drain finger, and the first source finger and the second source finger.

2. The semiconductor device according to claim 1, further comprising:
a via penetrating the substrate and connecting the first source finger to a metal layer provided under the substrate.

3. The semiconductor device according to claim 1 or 2, further comprising:
a third gate finger provided on the substrate and sandwiching the first source finger between the first gate finger and the third gate finger;
a third source finger provided on the substrate, having a width smaller than the width of the first source finger, extending in the stretching direction, being adjacent to the first gate wiring in the width direction, and sandwiching the first gate wiring between the second source finger and the third source finger, the width of the third source finger in the width direction being within the width of the first source finger;
a fourth gate finger provided on the substrate, sandwiching the third source finger between the first gate wiring and the fourth gate finger, and extending in an extension direction of the third gate finger;
a second drain finger provided on the substrate and sandwiching the third gate finger and the fourth gate finger between the second drain finger, and the first source finger and the third source finger; and
a second source wiring provided on the substrate and connecting the first source finger to the third source finger;
wherein the second gate wiring intersects the second source wiring in a non-contact manner and connects the first gate wiring to the third gate finger.

4. The semiconductor device according to any one of claims 1 to 3, further comprising:
a gate bus bar provided on a region of the substrate opposite to the first source finger with respect to the second source finger and connected to the first gate wiring.

5. The semiconductor device according to claim 4, wherein
the second gate finger has a first end connected to the gate bus bar, and a second end separated from the second gate wiring.

6. The semiconductor device according to claim 4, wherein
the second gate finger has a first end separated from the gate bus bar, and a second end connected to the second gate wiring.

7. The semiconductor device according to claim 4, wherein
the second gate finger has a first end connected to the gate bus bar, and a second end connected to the second gate wiring.

8. The semiconductor device according to claim 1 or 2, further comprising:
a third gate finger provided on the substrate and sandwiching the first source finger between the first gate finger and the third gate finger;
a third source finger provided on the substrate, having a width smaller than the width of the first source finger, extending in the stretching direction, being adjacent to the first gate wiring in the width direction, and sandwiching the first gate wiring between the second source finger and the third source finger, the width of the third source finger in the width direction being within the width of the first source finger,
a fourth gate finger provided on the substrate, sandwiching the third source finger between the first gate wiring and the fourth gate finger, and extending in an extension direction of the third gate finger;
a second drain finger provided on the substrate and sandwiching the third gate finger and the fourth gate finger between the second drain finger, and the first source finger and the third source finger; and
a second source wiring provided on the substrate and connecting the first source finger to the third source finger;
a third gate wiring provided on the substrate and between the third source finger and the first gate wiring, and separated from the first gate wiring on the substrate, the width of the third gate wiring in the width direction being within the width of the first source finger; and
a fourth gate wiring provided on the substrate, intersecting the second source wiring in a non-contact manner, separated from the second gate wiring on the substrate, and connecting the third gate wiring to the third gate finger.

9. The semiconductor device according to claim 8, further comprising:
a first gate bus bar provided on a region of the substrate opposite to the first source finger with respect to the second source finger and connected to the first gate wiring;
a second gate bus bar provided on a region of the substrate opposite to the first source finger with respect to the third source finger, connected to the first gate wiring, and separated from the first gate bus bar on the substrate; and
a resistor electrically connecting the first gate wiring and the first gate bus bar to the third gate wiring and the second gate bus bar.

10. The semiconductor device according to any one of claims 1 to 9, wherein
the substrate has a first active region and a second active region separated from each other and in which a semiconductor layer in the substrate is activated, and an inactive region provided between the first active region and the second active region and in which the semiconductor layer is deactivated,
the first source finger has a first source ohmic layer that makes ohmic contact with the first active region, and a first source low resistance layer provided in contact with the first source ohmic layer and having a sheet resistance lower than the first source ohmic layer,
the second source finger has a second source ohmic layer that makes ohmic contact with the second active region, and a second source low resistance layer provided in contact with the second source ohmic layer and having a sheet resistance lower than the second source ohmic layer,
the second gate wiring is provided on the inactive region, and
the first source wiring is continuous with the first source low resistance layer and the second source low resistance layer and is formed of the same material as the first source low resistance layer and the second source low resistance layer.

11. The semiconductor device according to claim 10, wherein
the first drain finger has a first drain ohmic layer that makes ohmic contact with the first active region, a second drain ohmic layer that makes ohmic contact with the second active region, and a drain low resistance layer in contact with the first drain ohmic layer and the second drain ohmic layer and having a lower sheet resistance than the first drain ohmic layer and the second drain ohmic layer.

12. The semiconductor device according to any one of claims 1 to 11, wherein
a material of the second gate wiring is the same as that of the first gate finger and the second gate finger.

13. The semiconductor device according to any one of claims 1 to 11, wherein a sheet resistance of the second gate wiring is lower than that of the first gate finger and the second gate finger.

14. A method for manufacturing a semiconductor device comprising:
forming, in a substrate, a first active region and a second active region separated from each other and in which a semiconductor layer is activated, and an inactive region provided between the first active region and the second active region and in which the semiconductor layer is deactivated;
forming, on the first active region, a first source ohmic layer and a first drain ohmic layer provided adjacent to the first source ohmic layer in a width direction of the first source ohmic layer and along the first source ohmic layer;
forming, on the second active region, a second source ohmic layer having a width smaller than the width of the first source ohmic layer and extending in an extension direction of the first source ohmic layer, the width of the second source ohmic layer in a width direction being within the width of the first source ohmic layer, and a second drain ohmic layer provided adjacent to the second source ohmic layer in a width direction of the second source ohmic layer and along the second source ohmic layer;
forming, on the first active region, a first gate finger sandwiched between the first source ohmic layer and the first drain ohmic layer and provided adjacent to the first source ohmic layer in the width direction of the first source ohmic layer and along the first source ohmic layer;
forming, on the second active region, a second gate finger sandwiched between the second source ohmic layer and the second drain ohmic layer and extending in an extension direction of the first gate finger;
forming, on the substrate, a first gate wiring sandwiching the second source ohmic layer between the second gate finger and the first gate wiring, the width of the first gate wiring in the width direction being within the width of the first source ohmic layer; and
forming, on the inactive region, a second gate wiring connecting the first gate finger to the first gate wiring.

15. The method for manufacturing the semiconductor device according to claim 14, further comprising:
forming a first source low resistance layer in contact with the first source ohmic layer and a second source low resistance layer in contact with the second source ohmic layer, wherein a source wiring connecting the first source low resistance layer to the second source low resistance layer and intersecting the second gate wiring in a non-contact manner is formed on the inactive region simultaneously with the first source low resistance layer and the second source low resistance layer.
